(19) Europäisches Patentamt / European Patent Office / Office européen des brevets

(11) **EP 3 760 788 B1**

(12) **EUROPEAN PATENT SPECIFICATION**

(45) Date of publication and mention
of the grant of the patent:
**26.01.2022 Bulletin 2022/04**

(21) Application number: **19184420.8**

(22) Date of filing: **04.07.2019**

(51) International Patent Classification (IPC):
**D21H 17/63** *(2006.01)*      **D21H 17/66** *(2006.01)*
**D21H 21/14** *(2006.01)*      **H01L 51/00** *(2006.01)*

(52) Cooperative Patent Classification (CPC):
**D21H 17/63; D21H 17/66; D21H 21/14;**
**H01L 51/0097;** Y02E 10/549; Y02P 70/50

(54) **SEMICONDUCTING PAPER COMPRISING CELLULOSE FIBRES**

HALBLEITENDES PAPIER MIT CELLULOSEFASERN

PAPIER SEMI-CONDUCTEUR COMPRENANT DES FIBRES DE CELLULOSE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.01.2021 Bulletin 2021/01**

(73) Proprietor: **RISE RESEARCH INSTITUTES OF
SWEDEN AB**
**501 15 Borås (SE)**

(72) Inventors:
• **BERGGREN, Magnus**
**602 18 Norrköping (SE)**

• **CRISPIN, Xavier**
**610 20 Kimstad (SE)**
• **JONSSON, Magnus**
**602 18 Norrköping (SE)**
• **ALVI, Naveed ul Hassan**
**602 16 Norrköping (SE)**

(74) Representative: **AWA Sweden AB**
**P.O. Box 11394**
**404 28 Göteborg (SE)**

(56) References cited:
**EP-A2- 2 282 359      FR-A- 1 212 292**

**Description**

Technical field

The present application relates to a process of manufacturing semiconducting paper comprising cellulose fibres, to a semiconducting paper comprising semiconductor structure coated cellulose fibres, and to an electronic device comprising the semiconducting paper.

Background art

Cellulose paper is ubiquitous in our daily life. For thousands of years, cellulose paper has been a major medium for displaying and transmitting information in many parts of the world. Cellulose can be obtained from plants and it is one of the most abundant organic materials on earth. The properties of cellulose include good chemical and mechanical stability under atmospheric conditions, high-tensile strength, low-shear strength, biodegradability, biocompatibility, good absorption capacity, excellent porosity, non-toxicity, reusability and recyclability. Cellulose by itself is usually limited in functionalities. Recently, research on organic/inorganic cellulose composites has increased dramatically due to the potential applications in electronics, biosensors, photocatalytic and energy storage devices [1-4].

ZnO is a functional material with semiconducting properties. It has wide direct bandgap (3.4 eV) and large exciton binding energy (60 meV). It is abundant, cheap, nontoxic, and can be fabricated using low temperature (< 100 °C), facile, cost-effective and scalable fabrication techniques. It has good physical and chemical stability and semiconducting properties [5-8]. It has very distinctive features, which together with the possibility of engineering different morphologies make this material a promising candidate for potential applications such as sunscreens, miniaturized lasers, sensors, transparent electrodes [9], piezoelectric nanodevices, [10, 11] hybrid diodes, [12] photodetectors and photocatalytic devices [13-15]. Remarkable efforts have been invested in growing ZnO nanostructures on various flexible plastics, polymers and paper substrates using extensive growth strategies [12, 16-18].

Pimentel et al disclose growing of ZnO on tracing and Whatman papers [19]. Gullapalli et al disclose growing of ZnO on printing paper [20]. Both disclosures [19-20] are based on further treatment of ready-made paper. Such growing methods are impractical for production of large amounts of semiconducting paper.

Summary of the invention

It is an object of the present invention to provide a process of manufacturing semiconducting paper that is feasible for large-scale production of semiconducting paper. It is another object of the present invention to provide a process of manufacturing semiconducting paper that results in a semiconducting paper having improved conductive properties.

These objects as well as other objects of the invention, which should be apparent to a person skilled in the art after having studied the description below, are accomplished by a process of manufacturing semiconducting paper comprising cellulose fibres, the process comprising:

- providing cellulose fibres,
- providing a semiconductor growth composition,
- combining the cellulose fibres with the semiconductor growth composition,
- growing semiconductor structures on the cellulose fibres to form semiconductor structure coated cellulose fibres, and
- draining liquid from a suspension of the semiconductor structure coated cellulose fibres to form semiconducting paper.

The growth of semiconductor structures, such as nanowires, on cellulose fibres before the papermaking process has significant importance and can bring real breakthroughs, opening up opportunities towards largescale production of flexible, lightweight, portable/wearable, biocompatible, economically cheap, and high-performance functional devices. These attributes make them attractive compared to flexible substrates and can induce impressive progress beyond the limits of traditional electronic and optoelectronics strategies.

Paper is a material consisting mainly of randomly distributed natural fibres and/or artificial fibres with or without the addition of size, fillers, pigments, dyes etc. Herein, the term "paper" is used as a general term to indicate both paper and board. A semiconductor, or a semiconducting material, is a material that is intermediate in electrical conductivity between a conductor and an insulator. Herein, the term "semiconducting paper" refers to paper that comprises a semiconducting material.

Cellulose is a carbohydrate, whose molecules comprise chains of glucose units linked by $\beta$-1,4-bonds. Cellulose is present in nature as fibres, forming the cell walls of plants. A fibril is a long slender structural element in the fibre wall, which in turn consists of still finer thread-like elements called microfibrils. Herein, the term "fibres" refers to fibres, fibrils and/or microfibrils of the cell wall, and/or to man-made fibres. Herein, the term "cellulose fibres" refers to fibres comprising cellulose. Cellulose fibres may be provided as wood fibers, which may be extracted from trees by chemical processes and/or mechanical treatments. Cellulose fibres may alternatively be provided as cotton fibers, which may be extracted from cotton plants by chemical processes and/or mechanical treatments.

A semiconductor is typically a crystalline solid. Crystal growth is a process in which a pre-existing crystal becomes larger as more molecules or ions add in their positions in the crystal lattice, or a solution is developed into a crystal and further growth is processed. Herein, the term "semiconductor growth composition" refers to a composition comprising molecules or ions, or precursors thereof, from which a semiconductor may be grown. The semiconductor growth composition need thus not contain the semiconductor as such.

The semiconductor structures may be semiconductor nanostructures and/or semiconductor microstructures. Herein, the term "nanostructure" refers to a structure that has an extension in at least one direction that is in the range of 1 to 1000 nm. Said extension of the nanostructure is preferably 10 to 500 nm, more preferably 10 to 100 nm. Herein, the term "microstructure" refers to a structure that has an extension in at least one direction that is in the range of 1 to 1000 $\mu$m. Said extension of the microstructure is preferably 10 to 500 $\mu$m, more preferably 10 to 100 $\mu$m. Herein, the terms "semiconductor nanostructure" or "semiconductor microstructure" thus refer to a structure of a semiconductor, which structure has the respective aforementioned extension. Herein, the expression "growing of semiconductor structures" thus refers to execution of crystal growth leading to the formation of semiconductor structures.

It is well known that crystal growth typically is facilitated by the presence of a surface on which the growth can proceed. The crystal formed thus adheres to the surface on which it was grown. In the present invention, the cellulose fibres serve as a surface on which the growth of semiconductor structures can proceed. The growing of semiconductor structures on the cellulose fibres thus leads to formation of semiconductor structure coated cellulose fibres. Herein, the expression "semiconductor structure coated cellulose fibres" refers to cellulose fibres to which semiconductor structures adhere. In this connection, the term "coated" means that at least a part of the surface of the cellulose fibres is coated, i.e. that semiconductor structures adhere to at least a part of said surface. It is preferred that substantially all of the surface of the cellulose fibres is coated.

A sheet or web of paper is conventionally obtained by dewatering of papermaking stock through a wire or screen cloth. Analogously, a semiconducting paper may be formed by draining liquid from a suspension of semiconductor structure coated cellulose fibres.

The process may further comprise, before combining the cellulose fibres with the semiconductor growth composition:

- providing a semiconductor seed composition,
- combining the cellulose fibres with the semiconductor seed composition, and
- seeding semiconductor material on the cellulose fibres.

Seeding of semiconductor material improves the adherence of the semiconductor structures to the cellulose fibres and/or facilitates growth of the semiconductor structures. Herein, the term "semiconductor seed composition" refers to a composition comprising molecules or ions, or precursors thereof, from which a semiconductor material may be seeded. The semiconductor seed composition need thus not contain the semiconductor material as such. Herein, the expression "seeding of semiconductor material" refers to the initial phase of developing a solution into a crystal leading to the formation of seeds of the semiconductor material. It is well known that seeding typically is facilitated by the presence of a surface on which the seeds may form. The seeds formed thus adheres to said surface. In the present process, the cellulose fibres may thus serve as a surface on which the seeding of semiconductor material can proceed. The seeding of semiconductor material on the cellulose fibres thus leads to formation of semiconductor seeds on the cellulose fibres. Growth of semiconductor structures may then proceed from the seeds.

The cellulose fibres may be provided as papermaking pulp. The cellulose fibres and/or the papermaking pulp may be pre-treated, as detailed below. The suspension of the semiconductor structure coated cellulose fibres may comprise further materials, such as a second papermaking pulp and/or other raw materials, such as size, fillers, pigments or dyes.

The semiconductor structures may be grown on the cellulose fibres by hydrothermal growth, preferably wherein the cellulose fibres are suspended in aqueous medium and the temperature is in the range of 15 to 100 °C, preferably 40 to 100 °C, more preferably 80 to 95 °C.

Seeding of the semiconductor material may take place on cellulose fibres suspended in aqueous medium, preferably at a temperature in the range of 10 to 40 °C, and wherein the seeding is preferably followed by removal of the aqueous medium. Removal of the aqueous medium may be performed by drying, such as by drying at a temperature in the range of 20 to 100 °C, preferably 50 to 100 °C, more preferably 70 to 90 °C.

The semiconductor may be one or more of silicon; a metal nitride, such as InN, GaN or InGaN; a metal oxide, such as ZnO, NiO or MnO$_2$, preferably ZnO; or a metal sulphide, such as CuS. The semiconductor is preferably ZnO. Formation of ZnO structures is discussed elsewhere in this document. Other metal oxide structures, and metal sulfide structures, may be formed following similar principles. Silicon structures may be formed in aqueous solution [21a]. Metal nitride structures may be formed by a chemical method at low temperature [21b].

In this work, we have grown highly dense ZnO structures on cellulose fibres by simple aqueous chemical approach before the papermaking process. We have investigated how the integration of ZnO structures to cellulose pulp fibres leads to a wide range of applications. The unique properties of ZnO structure/cellulose paper enable large-scale fabrication of the functional devices, which can be tailored to develop new concepts of energy and electronic devices. The ZnO structures grown may have a diameter of 10 to 100 nm, preferably 50 to 70 nm. The ZnO structures grown may have a length of 100 to 1000 nm, preferably 300 to 400 nm. These ZnO structures may thus be considered as ZnO nanostructures. Other semiconductor structures grown according to the present invention may as well have a diameter of 10 to 100 nm, preferably 50 to 70 nm, and/or a length of 100 to 1000 nm, preferably 300 to 400 nm.

The semiconductor growth composition may comprise a metal salt, preferably a Zn salt, more preferably Zn nitrate; or a siliconate, preferably sodium methylsiliconate; or a nitrogen source, such as HNO$_3$ or NH$_4$OH; and the growing of the semiconductor structures on the cellulose fibres may preferably take place at alkaline conditions.

The semiconductor seed composition may comprise a metal salt, preferably a Zn salt, more preferably Zn acetate; or a siliconate, preferably sodium methylsiliconate; or a nitrogen source, such as HNO$_3$ or NH$_4$OH; and the seeding of semiconductor material on the cellulose fibres may preferably take place at alkaline conditions.

Before, during and/or after the seeding and/or growing of semiconductor structures on the cellulose fibres, other materials, such as organic, conductive and/or semiconductive materials, may be applied to the cellulose fibres. In other words, the cellulose fibres provided in the process according to the invention may be pre-treated. As an example, the cellulose fibres may be pre-treated with metal or metal nanoparticles, which pretreatment may facilitate seeding and/or growing of silicon. The semiconductor structure coated cellulose fibres formed in the process according to the invention may be post-treated, e.g. by application of other materials, such as organic, conductive and/or semiconductive materials, before forming the semiconducting paper.

In other words, a process of manufacturing semiconducting paper comprising cellulose fibres may comprise the following sequential steps:

- providing aqueous cellulose pulp,
- subjecting the cellulose pulp to filtration,
- combining the filtered cellulose pulp with a semiconductor seed composition, preferably a ZnO seed solution,
- subjecting the cellulose pulp to seeding, preferably at a temperature in the range of 10 to 40 °C.
- subjecting the cellulose pulp to filtration,
- subjecting the cellulose pulp to drying, preferably at a temperature in the range of 20 to 100 °C, more preferably 50 to 100 °C, most preferably 70 to 90 °C,
- combining the cellulose pulp with a semiconductor growth composition, preferably a ZnO growth solution,
- subjecting the cellulose pulp to growth, preferably at temperature in the range of 15 to 100 °C, more preferably 40 to 100 °C, most preferably 80 to 95 °C,
- subjecting the cellulose pulp to filtration, thereby forming paper on the filter.

The above-mentioned objects are also accomplished by a semiconducting paper comprising semiconductor structure coated cellulose fibres, the semiconducting paper having a thickness, wherein the semiconductor structure coated cellulose fibres are essentially evenly distributed over the thickness of the semiconducting paper.

An essentially even distribution of the semiconductor structure coated cellulose fibres over the thickness of the semiconducting paper may be achieved by the above-mentioned process, i.e. by coating the cellulose fibres with semiconductor structures before forming the paper by draining liquid from a suspension of the coated fibres. The essentially even distribution of the semiconductor structure coated cellulose fibres over the thickness of the semiconducting paper is advantageous in respect of improving the conductivity of the semiconducting paper in a direction perpendicular to the paper surface, such as from one side of the paper to the other.

In the semiconducting paper, the cellulose fibres may contact each other via a layer of semiconductor material. By coating the cellulose fibres with semiconductor structures before forming the paper by draining liquid from a suspension of the coated fibres, cellulose fibres that end up in contact with each other in the paper may do so via a layer of semiconductor material. Accordingly, an extensive network of semiconductor material may form throughout the paper. The contact between cellulose fibres via a layer of semiconductor material is thus advantageous in respect of improving the conductivity of the semiconducting paper in all directions.

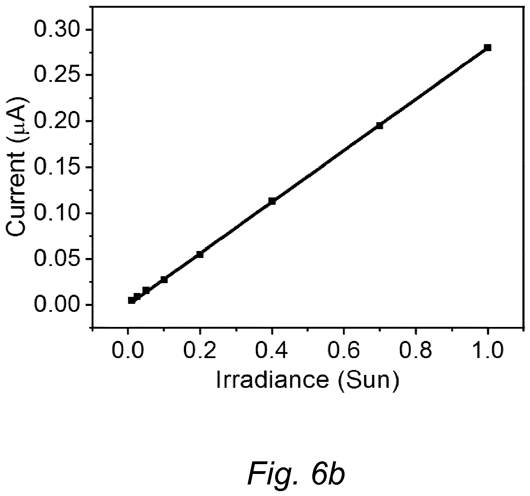

The semiconducting paper may have a bulk conductivity in the range of 10 to 100 $\mu$Sm$^{-1}$, preferably 50-75 $\mu$Sm$^{-1}$, when irradiated by 1 Sun at a bias of 1 V. Determination of the bulk conductivity is detailed below in connection with the discussion of Figure 6b.

The semiconducting paper may be further defined as in the process recited above.

The above-mentioned objects are also accomplished by an electronic device comprising the semiconducting paper disclosed above and at least one electrode. The electronic device may be a photo electrode, UV sensor, strain sensor, biosensor, LED, solar cell or piezoelectric generator.

A first electrode may be arranged on one side of the semiconducting paper and a second electrode may be arranged on the same or the opposite side of the semiconducting paper. A complex electronic device may thereby be produced, optionally relying on conductivity in a direction perpendicular to the paper surface, such as from one side of the paper to the other.

The electrode(s) may be printed or otherwise applied to the semiconducting paper. The electrode(s) may comprise any conductive material, such as carbon, silver or nickel.

Brief description of the drawings

Figs. 1 and 2 are SEM images of ZnO nanowires (ZnO-NWs) coated cellulose fibres.
Fig. 3 shows the absorption spectrum of ZnO-NWs paper at room temperature.
Fig. 4 shows the photoluminescence spectra of ZnO-NWs paper and blank paper at room temperature.
Figs. 5a and 5b show the stabilization curve and the photo response, respectively, of a ZnO-NWs paper device at a bias of 1 V and under an irradiance of 1 Sun.
Fig. 6a shows current versus irradiance of a ZnO-NWs paper device under a bias of 1 V.
Fig. 6b shows current versus irradiance of a ZnO-NWs paper device under a bias of 1 V.
Fig. 6c shows the UV sensitivity of a ZnO-NWs paper device under a bias of 1 V.
Figs. 7a and 7b are SEM images of a ZnO-NWs paper before and after shaking, respectively.
Fig. 8 shows the photo response of a ZnO-NWs paper before and after shaking.
Figs. 9a and 9b show the stabilisation curve and the photo response, respectively, of a 4 months old ZnO-NWs paper device at a bias of 1 V and under an irradiance of 1 Sun.

Example

Synthesis of ZnO nanowires on cellulose pulp fibers

ZnO nanowires (NWs) were grown on cellulose pulp by using a simple low temperature aqueous chemical growth method described by Vayssieres et al [22]. This method was preceded by a ZnO seeding solution technique introduced by Womelsdof et al. [23].

Using this seeding solution technique, we mixed 0.01 M zinc acetate dihydrate in methanol. This solution was heated to 60 °C for 2 hours under continuous stirring. During this process, we added 0.03 M KOH in methanol dropwise. Water was removed from cellulose pulp by filtration. A thin and uniform seeding layer of ZnO was formed by placing the cellulose pulp in the ZnO seeding solution for 3 minutes. Seeding solution was then removed from the cellulose pulp by filtration.

Using the aqueous chemical growth method, a growth solution was prepared by mixing an equimolar concentration (0.1 M) of zinc nitrate ($Zn(NO_3)_2 \cdot 6H_2O$) and hexa-methylene-tetramine (HMT, $C_6H_{12}N_4$). The cellulose pulp was placed in the solution and the solution container was placed in an oven at 90 °C for 4 hours.

The growth of ZnO nanorods proceeds through the following reactions [24]. At first, the HMT reacts with water and produces ammonia according to the following reaction.

$$(CH_2)_6N_4 + 6H_2O \rightarrow 6HCHO + 4NH_3$$

The ammonia produced in the above reaction reacts with water and disassociates into ammonium and hydroxide ions under the following reaction.

$$NH_3 + H_2O \rightarrow NH_4^+ + OH^-$$

The hydroxide ions produced in the above reaction react with zinc ions to grow solid ZnO nanowires according to the following reaction.

$$2OH^- + Zn^{2+} \rightarrow ZnO(s) + H_2O$$

Paper manufacture

After the growth, the cellulose pulp was moved out from the growth solution and growth solution was removed from the cellulose pulp by filtration. Finally, ZnO-NWs paper was manufactured by using a simple filtration process. A mixture of water and ZnO-NWs pulp fibers was filtered through a filter having a pore size of 10 $\mu$m. The water was filtered out and a uniform layer of ZnO-NWs pulp fibres was formed on the filter. The paper size was about 2 inch in diameter. It was dried at 100 °C for 1 hour and finally pressed under a weight of one ton.

Electrode Printing

We printed carbon electrode on the fabricated ZnO-NWs paper. Twoprobe interdigitated electrodes (2E) were printed to measure the photosensing properties, while four-probe square configured electrodes (4E) were printed to measure the sheet conductance and the bulk conductivity of the fabricated ZnO NWs paper. The electrode area was 0.5 cm$^2$. All electrodes were printed by using a screen-printing mask and carbon-based ink (7102, supplied by DuPont). A square arrangement of four probes was designed to avoid shadowing of the photoconductor by the probes/electrodes. After printing, the devices were dried at 120 °C in an oven for 5 min under ambient conditions.

Measurements

Morphological and structural characterizations of NWs were carried out with a scanning electron microscope, (Sigma 500 Gemini).
For absorption measurements, a 300 W xenon lamp (Newport) was used as the light source. Reflected light from the sample was directed towards and measured with a light guide connected to a spectrograph (Andor Shamrock 303i, with a Newton CCD detector).
For photoluminescence measurements we have used the 355 nm output beam of a pulsed neodymium-doped yttrium aluminum garnet laser (Tempest 10, New Wave Research), using a 355 nm laser line filter (Thorlabs) as the excitation light source. The emission spectrum was collected orthogonally to the excitation beam using a liquid light guide (Newport model 77569) at room temperature and sent to a spectrometer (Shamrock 303i, Newton detector, Andor Technology).
Photoconductive measurements were performed at room temperature using a LCS-100 Solar Simulator from Oriel Instruments as the light source. The system uses a 100W Xe lamp and an AM1.5G filter. The calibration of the light irradiance was done by using a calibrated reference cell and meter (91150-KG5 from Oriel Instruments). The current was measured and recorded with a Keithley 2400 source meter. A custom-designed LabVIEW program was used to control the equipment and gather the data on a personal computer. The sheet resistance of the paper material was obtained by illuminating the four-probe structure through a circular shadow mask, where the periphery coincides with the electrodes, and then calculated by using the square four-probe points configuration formula [25].

Results and discussions

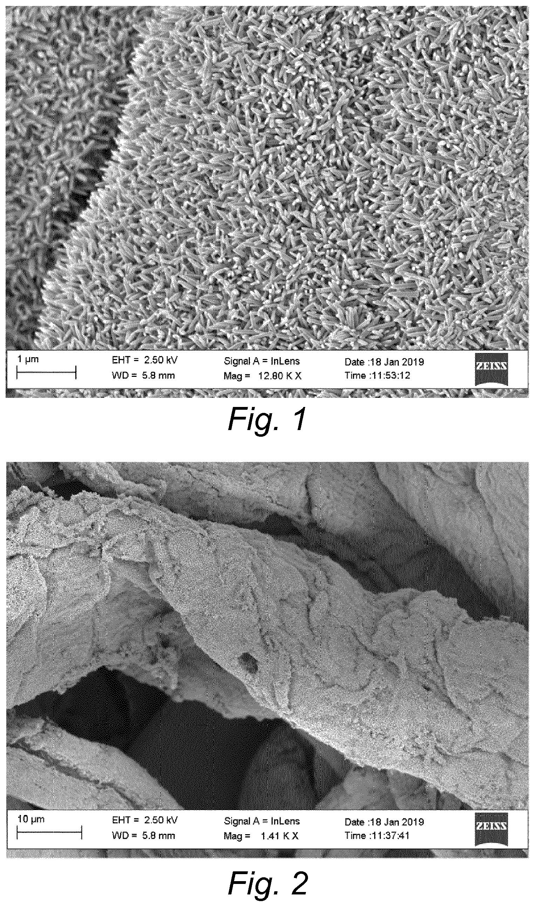

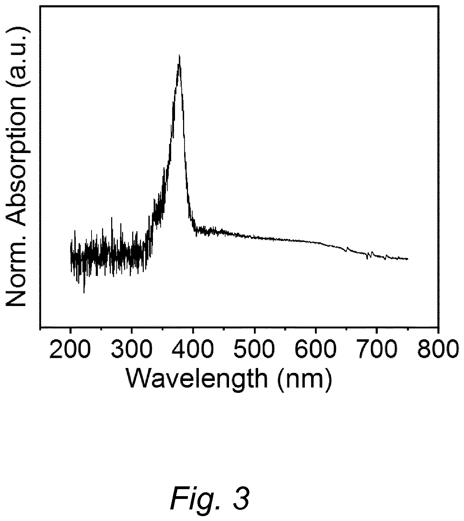

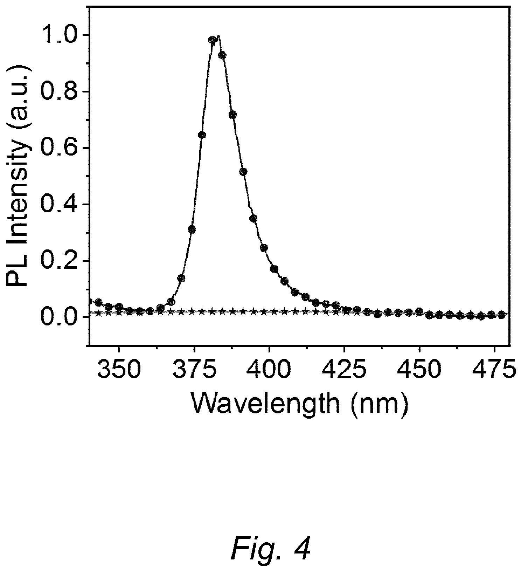

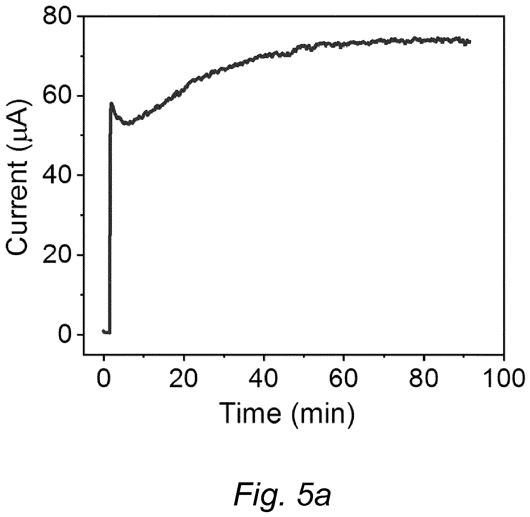

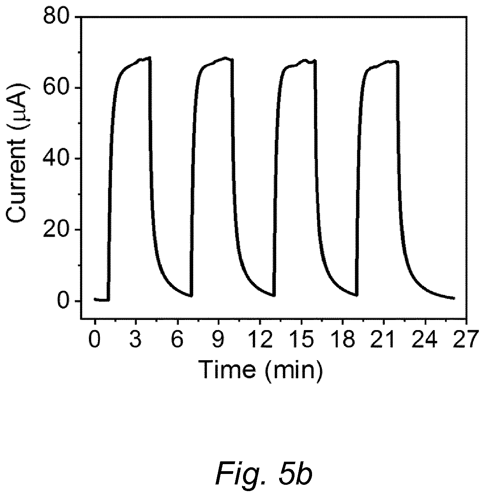

We have synthesized uniform and dense ZnO nanowires on cellulose fibres before the papermaking process. The diameter of the ZnO-NWs is around 50-70 nm and the average length is 300-400 nm. SEM images of the ZnO-NWs coated cellulose fibres are shown in Figs. 1 and 2.
The optical absorption spectrum of the ZnO-NWs paper at room temperature is shown in Fig. 3. A strong absorption band attributed to ZnO is observed at 378 nm in the UV domain.
The photoluminescence (PL) spectra of the ZnO-NWs paper (circles) and blank papers (stars) at room temperature upon excitation at 355 nm is shown in Fig. 4. A strong peak is observed at 382 nm for the ZnO-NWs paper. This emission is due to band edge emission and implies an excellent crystal quality.
The photoconductive response is a key figure of merit for photo sensor devices. Photoconductive measurements were performed under irradiance of 1 Sun (1000 Wm$^{-2}$). Initially, we measured photo response of ZnO NWs paper 2E devices for a long time of -90 minutes at a bias of 1.0 V (Fig. 5a).
The real-time ON/OFF switching was measured by applying a light pulse with an intensity of 1 Sun. Photocurrent pulse for all devices shows good stability and reversibility with a rapid rise and fall upon exposure to light. Fig. 5b illustrates the photo response switching behaviour of the ZnO-NWs paper 2E device. It shows that the photocurrent can be reproducibly switched from the "ON" to the "OFF" state with a sensitivity of 80 $((I_{max} - I_{min})/=I_{min})$. Here, $I_{max}$ = 68.40 $\mu$A and $I_{min}$ = 0.847 $\mu$A.
Typically, in the dark, a low conductivity is caused by the depletion layer formed near the surface by adsorbed oxygen molecules and free electrons in the n-type semiconductor. Under dark condition, oxygen molecules are adsorbed on the NWs surface and capture free electrons from the n-type ZnO, making negatively charged $O_2$ ions at the surface.

This generates a low conductivity depletion layer near the nanowire surface.

$$O_2 (g) + e^- \rightarrow O_2^- (ad)$$

When the light exposure is made, electron-hole pairs are photo-generated and holes are trapped at the surface by the oxygen ions via surface electron-hole recombination.

$$h^+ + O_2^- (ad) \rightarrow O_2(g)$$

Unpaired electrons are left behind which add to the photocurrent [26, 27]. Thus, the NWs are very suitable for obtaining higher sensitivity of the devices due to an enhanced surface to volume ratio.

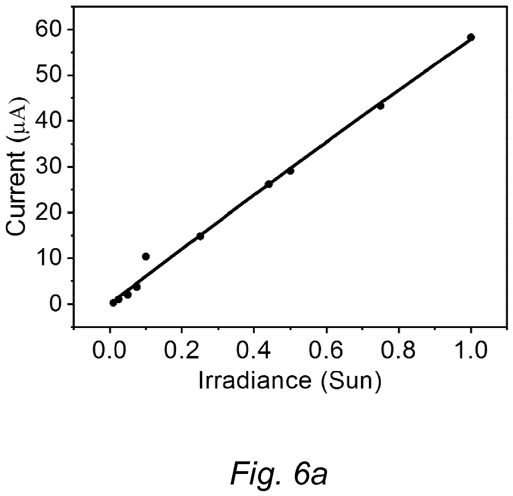

Fig. 6a shows a stable current measured at different irradiances (0.01-1.0 Sun) for the ZnO-NWs paper 2E device. The ZnO-NWs device thus shows a strong and stable photo response at different light irradiances spanning from 0.01-1.0 Sun.

In order to explain the variation of photocurrent of the device upon change in the intensity of the light irradiance, a model is used by considering a total device resistance (R) which is the sum of a constant resistance originating from leads and contacts ($R_c$), and a light-dependent resistance through the paper ($R_p$). The light-dependent resistance ($R_p$) is inversely proportional to the irradiance (E). The stable current (I) of the device is dependent on light irradiance (E) as

$$I = V/(S/E + R_c)$$

where S is a sensitivity factor, which depends on both the device geometry and the inherent sensitivity of the paper's conductivity to illumination. The experimental data were fitted well by using the above equation as shown in Fig. 6a. The total contact and lead resistance of the ZnO-NWs paper device ($R_c$) is 0.864 k$\Omega$ while the total resistance within the paper ($R_p$ = S/E) is found to increase inversely with illumination as 16.4 k$\Omega$ x Sun. The current varies approximately linearly with varying light intensities. The photocurrent upon different irradiation were also measured by using four probes (4E) as shown in Fig. 6b, which was used to extract the sheet resistance of the ZnO-NWs paper when illuminated at 1 Sun and at a bias of 1 V. The sheet resistance was found to be around 32 Mohm/square. For the roughly 0.5 mm thick paper, and assuming constant light intensity through the paper, this corresponds to a bulk conductivity of 61 $\mu$Sm$^{-1}$. The sheet resistance was extracted from the 4-point probe measurement using the equation

$$R_{sheet} = (2\pi/\ln2) \cdot (V/I)$$

disclosed in Table 1 of Miccoli et al., J. Phys.: Condens. Matter, vol 27, no 22, 2015.

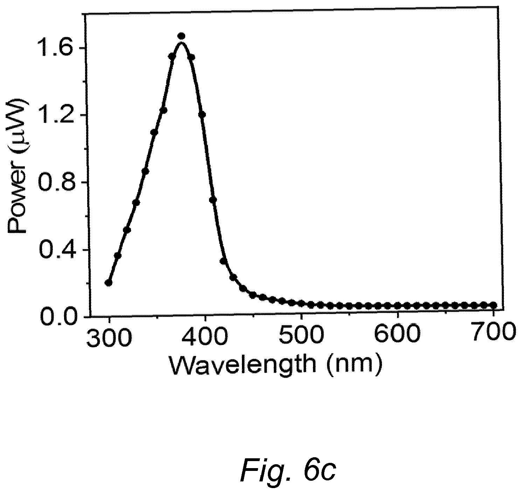

We have also investigated the UV sensitivity of the ZnO-NWs paper 2E device by investigating the photo response at different wavelengths in the range of 300-700 nm. The experiment was performed by changing the illumination wavelength while keeping a fixed bias voltage of 1 V (Fig. 6c). The plot resembles well with the absorption spectra of the ZnO-NWs paper as shown in figure 4.

In summary, this study is the first report of the integration of ZnO-NWs on cellulose fibres before the papermaking process. We have used a low-cost and simple aqueous chemical process which does not need a cleanroom environment to fabricate conducting paper at large scale. The fabricated ZnO-NWs cellulose paper is highly photoconductive, smooth, flexible, and mechanically strong, allowing applications in a range of flexible energy and electronics devices. We have investigated how the integration of ZnO nanowires to cellulose pulp fibres leads to a wide range of applications. The unique properties of ZnO nanowires/cellulose paper enable large-scale fabrication of the functional devices, which can be tailored to develop new concepts of energy and electronic devices.

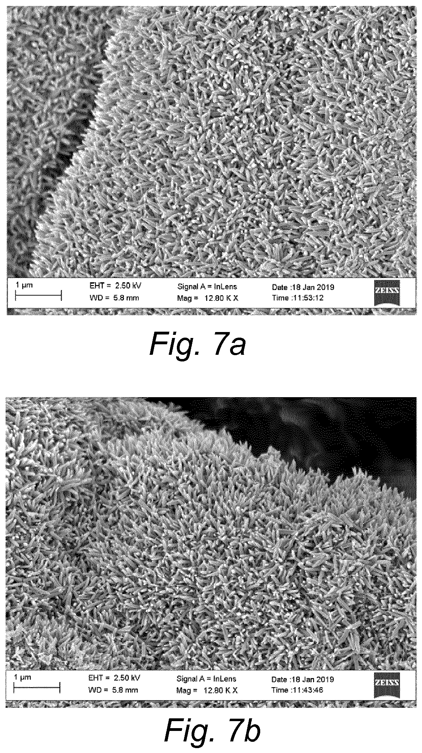

Figs. 7a and 7b show SEM images of ZnO-NWs paper before and after shaking, respectively. We shook the fabricated papers 20 times manually in the air and in water. A SEM images analysis reveals that the NWs are attached to the cellulose pulp fibres very strongly and are very stable and fully covering the cellulose fibres after shaking the paper.

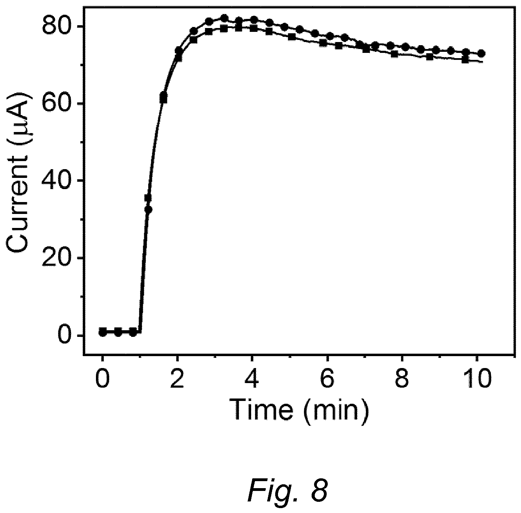

The photoconductive response of the shaken and unshaken ZnO-NWs papers was measured under irradiance of 1 Sun (1000 Wm$^{-2}$). ZnO-NWs paper had the same photo response before (circles) and after (squares) shaking as shown in Fig. 8.

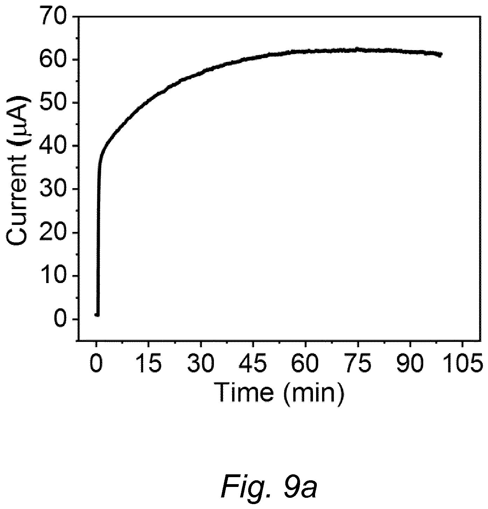

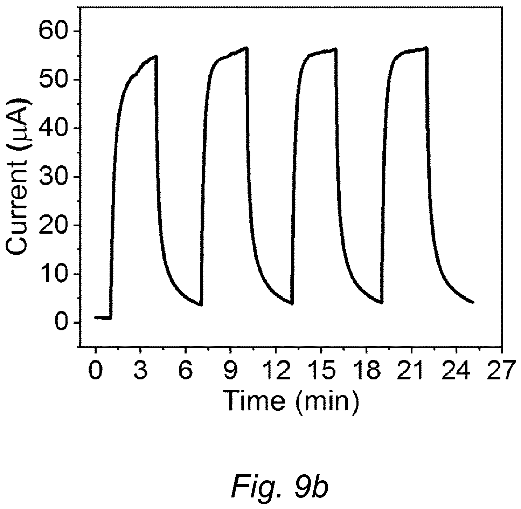

The ZnO-NWs paper has also shown the same and very stable photo response after 4 months of time as shown in Figs. 9a and 9b. This shows that the fabricated ZnO-NWs paper has excellent repeatability and durability with a full potential to be used for long term applications.

References

[1] G. Zheng, Y. Cui, E. Karabulut, L. Wågberg, H. Zhu, L. Hu, MRS BULLETIN 2013, 38, 320.
[2] R. J. Moon, A. Martini, J. Nairn, J. Simonsen, J. Youngblood, Chem. Soc. Rev. 2011, 40, 3941.
[3] D. Tobjörk, R. Osterbacka, Adv. Mater. 2011, 23, 1935.
[4] L. Nyholm, G. Nyström, A. Mihranyan, M. Strømme, Adv. Mater. 2011, 23, 3751.
[5] J. Gong, J. Liang, K. Sumathy, Renew. Sustain. Energy Rev. 16, 5848-5860 (2012).
[6] Schneider, J. et al. Chem. Rev. 114, 9919- 9986 (2014).
[7] X. Xu, C. Random, P. Efstathiou, J. T. S. Irvine, Nat. Mater. 11, 595-598 (2012).
[8] K. Subramanyam, N. Sreelekha, D. Amaranatha Reddy, G. Murali, K. Rahul Varma, R.P. Vijayalakshmi, Solid State Sciences 65, 68-78 (2017).
[9] D. C. Look, Mater Sci. Eng. B 2001, 80, 383.
[10] Z. L. Wang, J. Song, Science 2006, 312, 242.
[11] J. H. He, C. L. Hsin, J. Liu, L. J. Chen, Z. L. Wang, Adv. Mater. 2007, 19,781.
[12] A. Nadarajah, R. C. Word, J. Meiss, R. Könenkamp, Nano Lett. 2008, 8, 534.
[13] C. Soci, A. Zhang, B. Xiang, S. A. Dayeh, D. P. R. Aplin, J. Park, X. Y. Bao, Y. H. Lo, D. Wang, Nano Lett. 2007, 7, 1003.
[14] J. H. He, S. T. Ho, T. B. Wu, L. J. Chen, Z. L. Wang, Chem. Phys. Lett. 2007, 435, 119.
[15] H. Kind, H. Yan, B. Messer, M. Law, P. Yang, Adv. Mater. 2002, 14, 158.
[16] T. Y. Liu, H. C. Liao, C. C. Lin, S. H. Hu, S. Y. Chen, Langmuir 2006, 22, 5804.
[17] A. Manekkathodi, M. Y. Lu, C. W. Wang, L. J. Chen, Adv. Mater. 2010, 22, 4059.
[18] S. Mun, H. C. Kim, H. U. Ko, L. Zhai, J. W. Kim, J. Kim, Science and Technology of Advanced Materials 2017, 18(1), 437.
[19] A. Pimentel, A. Samouco, D. Nunes, A. Araújo, R. Martins, E. Fortunato, Materials 2017, 10, 1308.
[20] Gullapalli, H. et al, Small 6(15), 1641 (2010).
[21a] Park, NM. & Choi, CJ. Nano Res. (2014) 7: 898.
[21b] MotahherAbdallah Hassan Qa'eed, Synthesis of InN, GaN and InGaN nanoparticles by a chemical method at low temperature for solar cell applications, PhD thesis, 2016.
[22] L. Vayssieres, K. Kies, S. E. Lindquist, A. Hagfeldt, J. Phys. Chem. B 2001, 105, 3350.
[23] H. Womelsdorf, W. Hoheisel, G. Passing, U.S. Patent 2004, US 6,710,091 B1.
[24] M. Wang, C. H. Ye, Y. Zhang, G. M. Hua, H. X. Wang, M. G. Kong, J. Cryst. Growth. 2006, 33, 291.
[25] I. Miccoli, F. Edler, H. Pfnür, C. Tegenkamp, J. Phys. Condens. Matter 2015, 27, 223201.
[26] H. Kind, H. Yan, B. Messer, M. Law, P. Yang, Adv. Mater. 2002, 14, 158.
[27] C. Soci, A. Zhang, B. Xiang, S. A. Dayeh, D. P.R. Aplin, J. Park, X. Y. Bao, Y. H. Lo, D. Wang, Nano Lett. 2007, 7, 1003.

**Claims**

1. A process of manufacturing semiconducting paper comprising cellulose fibres, the process comprising:

   - providing cellulose fibres,
   - providing a semiconductor growth composition,
   - combining the cellulose fibres with the semiconductor growth composition,
   - growing semiconductor structures on the cellulose fibres to form semiconductor structure coated cellulose fibres, and
   - draining liquid from a suspension of the semiconductor structure coated cellulose fibres to form semiconducting paper.

2. The process of claim 1, further comprising, before combining the cellulose fibres with the semiconductor growth composition:

   - providing a semiconductor seed composition,
   - combining the cellulose fibres with the semiconductor seed composition, and
   - seeding semiconductor material on the cellulose fibres.

**3.** The process of claim 1 or 2, wherein the cellulose fibres are provided as papermaking pulp.

**4.** The process of any one of the preceding claims, wherein the semiconductor structures are grown on the cellulose fibres by hydrothermal growth, preferably wherein the cellulose fibres are suspended in aqueous medium and the temperature is in the range of 15 to 100 °C, preferably 40 to 100 °C, more preferably 80 to 95 °C.

**5.** The process of any one of claims 2 to 4, wherein seeding of the semiconductor material takes place on cellulose fibres suspended in aqueous medium, preferably at a temperature in the range of 10 to 40 °C, and wherein the seeding is preferably followed by removal of the aqueous medium.

**6.** The process of any one of the preceding claims, wherein the semiconductor is one or more of silicon; a metal nitride, such as InN, GaN or InGaN; a metal oxide, such as ZnO, NiO or $MnO_2$, preferably ZnO; or a metal sulphide, such as CuS.

**7.** The process according to any one of the preceding claims, wherein the semiconductor growth composition comprises a metal salt, preferably a Zn salt, more preferably Zn nitrate; or a siliconate, preferably sodium methylsiliconate; or a nitrogen source, such as $HNO_3$ or $NH_4OH$; and the growing of semiconductor structures on the cellulose fibres preferably takes place at alkaline conditions.

**8.** The process according to any one of claims 2 to 7, wherein the semiconductor seed composition comprises a metal salt, preferably a Zn salt, more preferably Zn acetate; or a siliconate, preferably sodium methylsiliconate; or a nitrogen source, such as $HNO_3$ or $NH_4OH$; and the seeding of semiconductor material on the cellulose fibres preferably takes place at alkaline conditions.

**9.** A semiconducting paper comprising semiconductor structure coated cellulose fibres, the semiconducting paper having a thickness, wherein the semiconductor structure coated cellulose fibres are essentially evenly distributed over the thickness of the semiconducting paper.

**10.** The semiconducting paper of claim 9, wherein cellulose fibres contact each other via a layer of semiconductor material.

**11.** The semiconducting paper of claim 9 or 10, having a bulk conductivity in the range of 10 to 100 $\mu Sm^{-1}$, preferably 50-75 $\mu Sm^{-1}$, when irradiated by 1 Sun at a bias of 1 V.

**12.** The semiconducting paper of any one of claims 9 to 11, further defined as in any one of claims 1 to 8.

**13.** An electronic device comprising the semiconducting paper of any one of claims 9 to 12 and at least one electrode.

**14.** The electronic device of claim 13, wherein a first electrode is arranged on one side of the semiconducting paper and a second electrode is arranged on the same or the opposite side of the semiconducting paper.


**Patentansprüche**

**1.** Verfahren zur Herstellung von halbleitendem Papier, umfassend Zellulosefasern, wobei das Verfahren umfasst:

- Bereitstellung von Zellulosefasern,
- Bereitstellen einer Halbleiterwachstumszusammensetzung,
- Kombinieren der Zellulosefasern mit der Halbleiterwachstumszusammensetzung,
- Züchten von Halbleiterstrukturen auf den Zellulosefasern zur Bildung von mit Halbleiterstrukturen beschichtete Zellulosefasern, und
- Ablassen von Flüssigkeit aus einer Suspension von mit Halbleiterstrukturen beschichtete Zellulosefasern, zur Bildung von halbleitendem Papier.

**2.** Verfahren nach Anspruch 1, ferner umfassend, vor dem Kombinieren der Zellulosefasern mit der Halbleiterwachstumszusammensetzung:

- Bereitstellen einer Halbleiterkeimzusammensetzung,
- Kombinieren der Zellulosefasern mit der Halbleiterkeimzusammensetzung, und
- Aussäen von Halbleitermaterial auf die Zellulosefasern.

3. Verfahren nach Anspruch 1 oder 2, wobei die Zellulosefasern als Zellstoff für die Papierherstellung bereitgestellt werden.

4. Verfahren nach einem der vorhergehenden Ansprüche, wobei die Halbleiterstrukturen auf den Zellulosefasern durch hydrothermales Wachstum gezüchtet werden, wobei die Zellulosefasern vorzugsweise in einem wässrigen Medium suspendiert sind und die Temperatur im Bereich von 15 bis 100 °C, vorzugsweise 40 bis 100 °C, besonders bevorzugt 80 bis 95 °C, liegt.

5. Verfahren nach einem der Ansprüche 2 bis 4, wobei die Aussaat des Halbleitermaterials auf Zellulosefasern erfolgt, die in einem wässrigen Medium suspendiert sind, vorzugsweise bei einer Temperatur im Bereich von 10 bis 40 °C, und wobei die Aussaat vorzugsweise von der Entfernung des wässrigen Mediums gefolgt wird.

6. Verfahren nach einem der vorhergehenden Ansprüche, wobei der Halbleiter eines oder mehrere der folgenden ist: Silizium; ein Metallnitrid, wie InN, GaN oder InGaN; ein Metalloxid, wie ZnO, NiO oder $MnO_2$, vorzugsweise ZnO; oder ein Metallsulfid, wie z.B. CuS.

7. Verfahren nach einem der vorhergehenden Ansprüche, wobei die Halbleiterwachstumszusammensetzung ein Metallsalz umfasst, vorzugsweise ein Zn-Salz, mehr bevorzugt Zn-Nitrat; oder ein Silikonat, vorzugsweise Natriummethylsilikonat; oder eine Stickstoffquelle, wie $HNO_3$ oder $NH_4OH$; und das Wachstum der Halbleiterstrukturen auf den Zellulosefasern vorzugsweise unter alkalischen Bedingungen erfolgt.

8. Verfahren nach einem der vorhergehenden Ansprüche, wobei die Halbleiterkeimzusammensetzung ein Metallsalz umfasst, vorzugsweise ein Zn-Salz, mehr bevorzugt Zn-Acetat; oder ein Silikonat, vorzugsweise Natriummethylsilikonat; oder eine Stickstoffquelle, wie $HNO_3$ oder $NH_4OH$; und das Wachstum der Halbleiterstrukturen auf den Zellulosefasern vorzugsweise unter alkalischen Bedingungen erfolgt.

9. Halbleiterpapier, umfassend eine mit Halbleiterstrukturen beschichtete Zellulosefasern, wobei das Halbleiterpapier eine Dicke aufweist, wobei die mit Halbleiterstrukturen beschichtete Zellulosefasern im Wesentlichen gleichmäßig über die Dicke des Halbleiterpapiers verteilt sind.

10. Halbleiterpapier nach Anspruch 9, wobei die Zellulosefasern miteinander über eine Schicht aus Halbleitermaterial in Kontakt stehen.

11. Halbleiterpapier nach Anspruch 9 oder 10, mit einer Gesamtleitfähigkeit im Bereich von 10 bis 100 $\mu Sm^{-1}$, vorzugsweise 50-75 $\mu Sm^{-1}$, bei Bestrahlung mit 1 Sonne bei einer Vorspannung von 1 V.

12. Halbleiterpapier nach einem der Ansprüche 9 bis 11, ferner definiert wie in einem der Ansprüche 1 bis 8.

13. Elektronische Vorrichtung, umfassend das Halbleiterpapier nach einem der Ansprüche 9 bis 12 und mindestens eine Elektrode.

14. Elektronische Vorrichtung nach Anspruch 13, wobei eine erste Elektrode auf einer Seite des Halbleiterpapiers und eine zweite Elektrode auf der gleichen oder der gegenüberliegenden Seite des Halbleiterpapiers angeordnet ist.

**Revendications**

1. Procédé de fabrication de papier semi-conducteur comprenant des fibres de cellulose, le procédé comprenant :

  - la fourniture de fibres de cellulose,
  - la fourniture d'une composition de croissance de semi-conducteur,
  - la combinaison des fibres de cellulose avec la composition de croissance de semi-conducteur,
  - la croissance de structures semi-conductrices sur les fibres de cellulose pour former des fibres de cellulose revêtues de structure semi-conductrice, et

- l'égouttage du liquide d'une suspension de fibres de cellulose revêtues de structure semi-conductrice pour former un papier semi-conducteur.

2. Procédé selon la revendication 1, comprenant en outre, avant la combinaison des fibres de cellulose avec la composition de croissance de semi-conducteur :

- la fourniture d'une composition de germe de semi-conducteur,
- la combinaison des fibres de cellulose avec la composition de germe de semi-conducteur, et
- la germination de matériau semi-conducteur sur les fibres de cellulose.

3. Procédé selon la revendication 1 ou 2, dans lequel les fibres de cellulose sont fournies sous forme de pâte à papier.

4. Procédé selon l'une quelconque des revendications précédentes, dans lequel les structures semi-conductrices croissent sur les fibres de cellulose par croissance hydrothermale, de préférence dans lequel les fibres de cellulose sont en suspension dans un milieu aqueux et la température est dans la plage de 15 à 100 °C, de préférence 40 à 100 °C, plus préférablement de 80 à 95 °C.

5. Procédé selon l'une quelconque des revendications 2 à 4, dans lequel la germination du matériau semi-conducteur a lieu sur des fibres de cellulose en suspension dans un milieu aqueux, de préférence à une température dans la plage de 10 et 40 °C, et dans lequel la germination est de préférence suivie d'un retrait du milieu aqueux.

6. Procédé selon l'une quelconque des revendications précédentes, dans lequel le semi-conducteur est un ou plusieurs parmi le silicium ; un nitrure métallique, tel que InN, GaN ou InGaN ; un oxyde métallique, tel que ZnO, NiO ou $MnO_2$, de préférence ZnO ; ou un sulfure métallique, tel que CuS.

7. Procédé selon l'une quelconque des revendications précédentes, dans lequel la composition de croissance de semi-conducteur comprend un sel métallique, de préférence un sel de Zn, plus préférablement du nitrate de Zn ; ou un siliconate, de préférence le méthylsiliconate de sodium ; ou une source d'azote, telle que $HNO_3$ ou $NH_4OH$ ; et la croissance des structures semi-conductrices sur les fibres de cellulose a lieu de préférence dans des conditions alcalines.

8. Procédé selon l'une quelconque des revendications 2 à 7, dans lequel la composition de germe de semi-conducteur comprend un sel métallique, de préférence un sel de Zn, plus préférablement de l'acétate de Zn ; ou un siliconate, de préférence le méthylsiliconate de sodium ; ou une source d'azote, telle que $HNO_3$ ou $NH_4OH$ ; et la germination de matériau semi-conducteur sur les fibres de cellulose a lieu de préférence dans des conditions alcalines.

9. Papier semi-conducteur comprenant des fibres de cellulose revêtues de structure semi-conductrice, le papier semi-conducteur ayant une épaisseur, dans lequel les fibres de cellulose revêtues de structure semi-conductrice sont essentiellement réparties uniformément sur l'épaisseur du papier semi-conducteur.

10. Papier semi-conducteur selon la revendication 9, dans lequel les fibres de cellulose sont en contact les unes avec les autres via une couche de matériau semi-conducteur.

11. Papier semi-conducteur selon la revendication 9 ou 10, ayant une conductivité volumique dans la plage de 10 à 100 $\mu Sm^{-1}$, de préférence 50-75 $\mu Sm^{-1}$, lorsqu'il est irradié par 1 Sun à une polarisation de 1 V.

12. Papier semi-conducteur selon l'une quelconque des revendications 9 à 11, défini en outre comme dans l'une quelconque des revendications 1 à 8.

13. Dispositif électronique comprenant le papier semi-conducteur selon l'une quelconque des revendications 9 à 12 et au moins une électrode.

14. Dispositif électronique selon la revendication 13, dans lequel une première électrode est disposée sur une face du papier semi-conducteur et une deuxième électrode est disposée sur la même face ou la face opposée du papier semi-conducteur.

| 1 μm | EHT = 2.50 kV | Signal A = InLens | Date :18 Jan 2019 | ZEISS |
| | WD = 5.8 mm | Mag = 12.80 K X | Time :11:53:12 | |

*Fig. 1*

| 10 μm | EHT = 2.50 kV | Signal A = InLens | Date :18 Jan 2019 | ZEISS |
| | WD = 5.8 mm | Mag = 1.41 K X | Time :11:37:41 | |

*Fig. 2*

*Fig. 3*

*Fig. 4*

*Fig. 5a*

*Fig. 5b*

Fig. 6a

*Fig. 6b*

*Fig. 6c*

*Fig. 7a*

*Fig. 7b*

Fig. 8

*Fig. 9a*

*Fig. 9b*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6710091 B1, H. Womelsdorf, W. Hoheisel, G. Passing

**Non-patent literature cited in the description**

- **MICCOLI et al.** *J. Phys.: Condens. Matter,* 2015, vol. 27 (22
- **G. ZHENG ; Y. CUI ; E. KARABULUT ; L. WÅGBERG ; H. ZHU ; L. HU.** *MRS BULLETIN,* 2013, vol. 38, 320
- **R. J. MOON ; A. MARTINI ; J. NAIRN ; J. SIMONSEN ; J. YOUNGBLOOD.** *Chem. Soc. Rev.,* 2011, vol. 40, 3941
- **D. TOBJÖRK ; R. OSTERBACKA.** *Adv. Mater.,* 2011, vol. 23, 1935
- **L. NYHOLM ; G. NYSTRÖM ; A. MIHRANYAN ; M. STRØMME.** *Adv. Mater.,* 2011, vol. 23, 3751
- **J. GONG ; J. LIANG ; K. SUMATHY.** *Renew. Sustain. Energy Rev.,* 2012, vol. 16, 5848-5860
- **SCHNEIDER, J. et al.** *Chem. Rev.,* 2014, vol. 114, 9919-9986
- **X. XU ; C. RANDOM ; P. EFSTATHIOU ; J. T. S. IRVINE.** *Nat. Mater.,* 2012, vol. 11, 595-598
- **K. SUBRAMANYAM ; N. SREELEKHA ; D. AMARANATHA REDDY ; G. MURALI ; K. RAHUL VARMA ; R.P. VIJAYALAKSHMI.** *Solid State Sciences,* 2017, vol. 65, 68-78
- **D. C. LOOK.** *Mater Sci. Eng. B,* 2001, vol. 80, 383
- **Z. L. WANG ; J. SONG.** *Science,* 2006, vol. 312, 242
- **J. H. HE ; C. L. HSIN ; J. LIU ; L. J. CHEN ; Z. L. WANG.** *Adv. Mater.,* 2007, vol. 19, 781
- **A. NADARAJAH ; R. C. WORD ; J. MEISS ; R. KÖNENKAMP.** *Nano Lett.,* 2008, vol. 8, 534
- **C. SOCI ; A. ZHANG ; B. XIANG ; S. A. DAYEH ; D. P. R. APLIN ; J. PARK ; X. Y. BAO ; Y. H. LO ; D. WANG.** *Nano Lett.,* 2007, vol. 7, 1003

- **J. H. HE ; S. T. HO ; T. B. WU ; L. J. CHEN ; Z. L. WANG.** *Chem. Phys. Lett.,* 2007, vol. 435, 119
- **H. KIND ; H. YAN ; B. MESSER ; M. LAW ; P. YANG.** *Adv. Mater.,* 2002, vol. 14, 158
- **T. Y. LIU ; H. C. LIAO ; C. C. LIN ; S. H. HU ; S. Y. CHEN.** *Langmuir,* 2006, vol. 22, 5804
- **A. MANEKKATHODI ; M. Y. LU ; C. W. WANG ; L. J. CHEN.** *Adv. Mater.,* 2010, vol. 22, 4059
- **S. MUN ; H. C. KIM ; H. U. KO ; L. ZHAI ; J. W. KIM ; J. KIM.** *Science and Technology of Advanced Materials,* 2017, vol. 18 (1), 437
- **A. PIMENTEL ; A. SAMOUCO ; D. NUNES ; A. ARAÚJO ; R. MARTINS ; E. FORTUNATO.** *Materials,* 2017, vol. 10, 1308
- **GULLAPALLI, H. et al.** *Small,* 2010, vol. 6 (15), 1641
- **PARK, NM. ; CHOI, CJ.** *Nano Res.,* 2014, vol. 7, 898
- **L. VAYSSIERES ; K. KIES ; S. E. LINDQUIST ; A. HAGFELDT.** *J. Phys. Chem. B,* 2001, vol. 105, 3350
- **M. WANG ; C. H. YE ; Y. ZHANG ; G. M. HUA ; H. X. WANG ; M. G. KONG.** *J. Cryst. Growth,* 2006, vol. 33, 291
- **I. MICCOLI ; F. EDLER ; H. PFNÜR ; C. TEGENKAMP.** *J. Phys. Condens. Matter,* 2015, vol. 27, 223201
- **C. SOCI ; A. ZHANG ; B. XIANG ; S. A. DAYEH ; D. P.R. APLIN ; J. PARK ; X. Y. BAO ; Y. H. LO ; D. WANG.** *Nano Lett.,* 2007, vol. 7, 1003